**Europäisches Patentamt**

**European Patent Office**

**Office européen des brevets**

(19)

(11) Veröffentlichungsnummer: **0 361 572**
**A1**

# (12) EUROPÄISCHE PATENTANMELDUNG

(21) Anmeldenummer: **89202242.7**

(22) Anmeldetag: **06.09.89**

(51) Int. Cl.⁵: **H01L 23/485 , H01L 21/320**

Die Bezeichnung der Erfindung wurde geändert (Richtlinien für die Prüfung im EPA, A-III, 7.3).

(30) Priorität: **09.09.88 DE 3830720**

(43) Veröffentlichungstag der Anmeldung:
**04.04.90 Patentblatt 90/14**

(84) Benannte Vertragsstaaten:
**DE FR GB IT NL**

(71) Anmelder: **N.V. Philips' Gloeilampenfabrieken**
**Groenewoudseweg 1**
**NL-5621 BA Eindhoven(NL)**

(72) Erfinder: **Wolters, Robertus Adrianos Maria, Dr.**
**Groenewoudseweg 1**
**NL-5621 BA Eindhoven(NL)**
Erfinder: **Doomernik-v.d. Els, Rosa Maria Johanna Franziska**
**Groenewoudseweg 1**
**NL-5621 BA Eindhoven(NL)**

(74) Vertreter: **David, Günther M. et al**
**Philips Patentverwaltung GmbH**
**Wendenstrasse 35 Postfach 10 51 49**
**D-2000 Hamburg 1(DE)**

(54) **Verfahren zum Herstellen von Leiterbahnen auf Halbleiterbauelementen.**

(57) Verfahren zum Herstellen von Halbleiterbauelementen, bei dem auf einer Oberfläche eines Halbleiterkörpers Leiterbahnen dadurch gebildet werden, daß durch insbesondere Sputtern eine Schicht aus Al(Si,Cu) abgeschieden und anschließend durch Ätzen strukturiert wird. In einer solchen Schicht werden an der Grenze zu der Oberfläche größere Ausfällungen (precipitates) aus $CuAl_2$ gebildet, die insbesondere beim Ätzen in einem Cl-haltigen Plasma aber schlecht geätzt werden, was zu unscharfen Konturen der Leiterbahnen führen kann. Um solche Ausfällungen an der genannten Oberfläche zu vermeiden und eine homogene Verteilung des Cu in der Schicht zu erreichen wird zur Bildung der Schicht zunächst soviel Al(Si) abgeschieden, daß sich gerade eine kontinuierliche, zusammenhängende Schicht bildet und dann im selben Arbeitsgang weiter Al(Si,Cu) abgeschieden, bis die gewünschte Schichtdicke erreicht ist.

FIG.4

# Verfahren zum Herstellen von Halbleiterbauelementen

Die Erfindung betrifft ein Verfahren zum Herstellen von Halbleiterbauelementen, bei dem auf einer Oberfläche eines Halbleiterkörpers Leiterbahnen dadurch gebildet werden, daß durch insbesondere Sputtern eine Schicht aus Al (Si, Cu) abgeschieden und anschließend durch Ätzen strukturiert wird.

Ein Verfahren dieser Art ist aus J. Electrochem. Soc.: Solid State Science and Technology 133-(1986)7, 1489-91 bekannt.

Bei der Herstellung von Halbleiterbauelementen, insbesondere integrierten Schaltungen haben sich durch insbesondere Sputtern niedergeschlagene Schichten aus Al (Si, Cu), mit z.B. 0 bis 2 Gew.% Si und 0,5 - 4 Gew.% Cu als Verbindungsleitungen gut bewährt.

Während des Aufsputterns einer solchen Al (Si,Cu)-Schicht auf eine durch z.B. TiW,SiO$_2$,TiN,Si$_3$N$_4$,Si,W oder A$_2$O$_3$ gebildeten Oberfläche werden an der Grenze zu dieser Oberfläche etwa 0,1 mm große Ausfällungen (precipitates) aus CuA$_2$ gebildet. Mit einer Temperaturbehandlung werden diese Ausfällungen in der Al-Schicht gelöst und als kleinere Ausfällungen an den Al-Korngrenzen abgeschieden. Insbesondere Elektromigrationseffekte sind dadurch weitgehend unterdrückt.

Werden aus einer solchen Schicht durch Ätzen in einem Cl-haltigen Plasma (z.B. Cl$_2$ + BCl$_3$ + Ar) die gewünschten Leiterbahnen gebildet so werden die CuAl$_2$-Ausfällungen schlecht geätzt, was zu unscharfen Konturen der Leiterbahnen führen kann. Außerdem besteht die Gefahr, daß ein Überätzen auftritt, also das Substrat angeätzt wird. Es ist also eine hohe Ätzselektivität erforderlich. Bei schon sehr kleinen Strukturen besteht zudem die Gefahr, daß durch die genannten Ausfällungen Kurzschlüsse hervorgerufen werden.

Aus J.Appl.Phys. 59 (Juni 1986) 11, 3768 - 3773 ist es bereits bekannt, daß bei Al (Si, Cu)-Schichten die bei Raumtemperatur durch Sputtern abgeschieden werden, nur in geringerem Maße Ausfällungen von Cu auftreten.

Der Erfindung liegt die Aufgabe zugrunde, ein Verfahren der eingangs genannten Art so weiterzubilden, daß eine möglichst homogene Al (Si, Cu)-Schicht erhalten wird, die sich, insbesondere in einem Cl-haltigen Plasma, gut ätzen läßt.

Erfindungsgemäß wird diese Aufgabe dadurch gelöst, daß zunächst soviel Al (Si) abgeschieden wird, daß sich gerade eine kontinuierliche Schicht bildet und dann im selben Arbeitsgang weiter Al (Si, Cu) abgeschieden wird bis die gewünschte Schichtdicke erreicht ist.

Bei einem solchen Verfahren werden weder an der Oberfläche aus z.B. SiO$_2$ noch an der Grenzfläche zwischen Al (Si) und Al(Si,Cu) AlCu-Ausfällungen gebildet. Weiter ist das Cu-homogen in der Al(Si,Cu)-Schicht verteilt. Die gebildete Schicht läßt sich sehr gut in einem Cl-haltigen Plasma ätzen. Wird die Schicht nach dem Ätzen einer Temperaturbehandlung unterworfen, so sind die wegen der geringeren Elektromigration gewünschten Ausfällungen an den Korngrenzen homogen über die gesamte Schicht verteilt.

Weitere Ausgestaltungen der Erfindung ergeben sich aus den Unteransprüchen.

Insbesondere wird zunächst Al (Si) bei einer Temperatur zwischen 100 und 150 °C abgeschieden. Daher ergibt sich eine Dicke der kontinuierlichen Schicht von etwa 50 nm. Anschließend wird Al (Si,Cu) bei einer erhöhten Temperatur zwischen 200 und 400 °C abgeschieden.

Die Dicke der ersten kontinuierlichen, d.h. gerade zusammenhängenden, Al(Si)-Schicht hängt insbesondere von der Temperatur beim Niederschlagen ab. Wenn die Schicht bei Raumtemperatur niedergeschlagen wird, so ist sie bei einer Dicke von 30 nm kontinuierlich, bei einer Niederschlagstemperatur von 250 °C bei einer Dicke von 120 nm und bei einer Niederschlagstemperatur von 400 °C bei einer Dicke von 300 nm. Diese Werte hängen zudem von weiteren Niederschlagsbedingungen (Art der Apparatur, Niederschlagsgeschwindigkeit etc.) ab.

Ein Ausführungsbeispiel der Erfindung wird im folgenden anhand der beigefügten Zeichnungen näher erläutert.

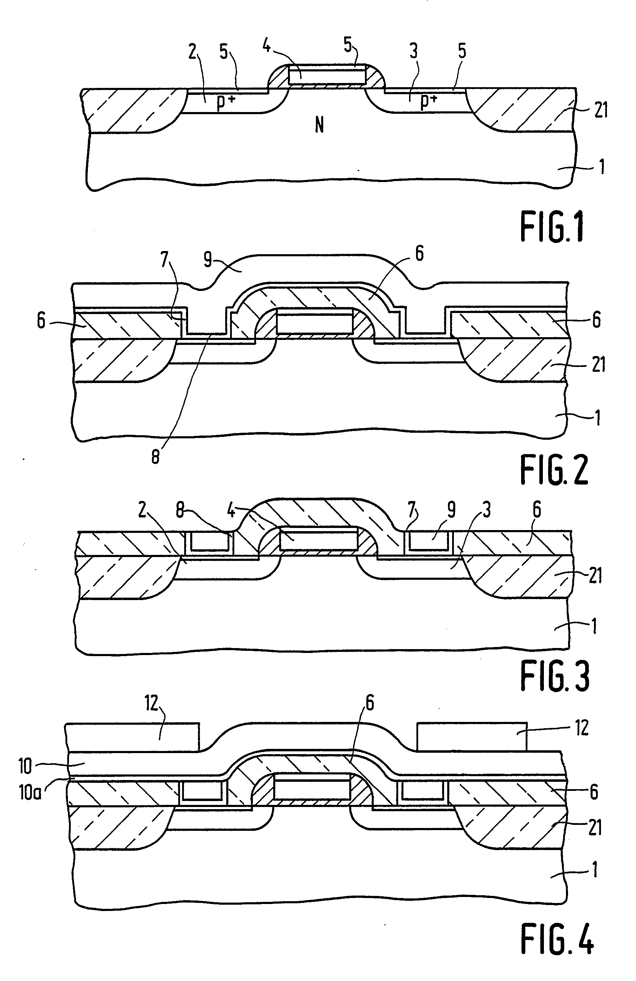

Die Figuren 1-6 zeigen einen Querschnitt durch einen Teil eines nach dem erfindungsgemäßen Verfahren hergestellten Halbleiterbauelements in aufeinanderfolgenden Stufen der Herstellung. Die Abmessungen, insbesondere die Dicke der einzelnen Schichten, sind dabei - der größeren Anschaulichkeit halber - nicht maßstäblich gewählt.

Figur 1 zeigt einen in einem N-leitenden Halbleiterkörper 1 aus Silicium gebildeten p-Kanal-MOS-Transistor bei dem Source 1, Drain 2 und das aus poly-Si bestehende Gate 4 nach dem bekannten Salicide (Self Aligned Silicide)-Verfahren mit einer TiSi$_2$-Schicht 5 bedeckt sind. Das versenkte Feldoxid ist mit 21 bezeichnet.

Fig. 2 zeigt diese dann mit einer Siliciumoxidschicht 6 bedeckte Struktur bei der die Schicht 6 mit Kontaktöffnungen 7 versehen und mit einer Verbindungsschicht 8 aus TiW und einer Wolfram-Schicht 9 bedeckt ist.

Die TiW-Schicht 8 und die W-Schicht 9 werden dann abgeätzt, so daß, wie Figur 3 zeigt, die Kontaktöffnungen 7 mit Wolfram gefüllt sind.

Auf die jetzt freiliegende durch Siliciumoxid und Wolfram gebildete Oberfläche wird dann durch das erfindungsgemäße Verfahren eine Al(Si,Cu)-Schicht 10 mit 1 Gew.% Si und 2 Gew.% Cu aufgebracht.

Dazu wird der Halbleiterkörper (Wafer) in eine Sputter-Anlage (DC-Magnetron-Anlage) eingebracht und diese dann bis auf einen Druck kleiner $1 \times 10^{-4}$ Pa evakuiert. Dann wird die Anlage für 10 Minuten auf 250 °C vorgeheizt und anschließend wieder auf einen Druck kleiner als $7 \times 10^{-5}$ Pa evakuiert und dann mit einem Inertgas, z.B. Argon bis zu einem Druck von $9 \times 10^{-1}$ Pa gefüllt. Anschließend wird bei einer Leistung von etwa 10 kW eine kontinuierliche, d.h. gerade zusammenhängende, etwa 50 nm dikke Schicht 10a aus Al (Si) mit 1 % Si abgeschieden. Die Wafer rotieren dabei in der Anlage. Unmittelbar anschließend wird dann ohne das Verfahren zu unterbrechen, die endgültige Al (Si,Cu)-Schicht 10 mit 1 Gew.% Si und 2 Gew.% Cu bei gleicher Leistung bis zu einer Gesamtdicke der Schicht von 0,5 μm abgeschieden. Die Temperatur beträgt dabei etwa 300 °C. Anschließend wird der Wafer entnommen.

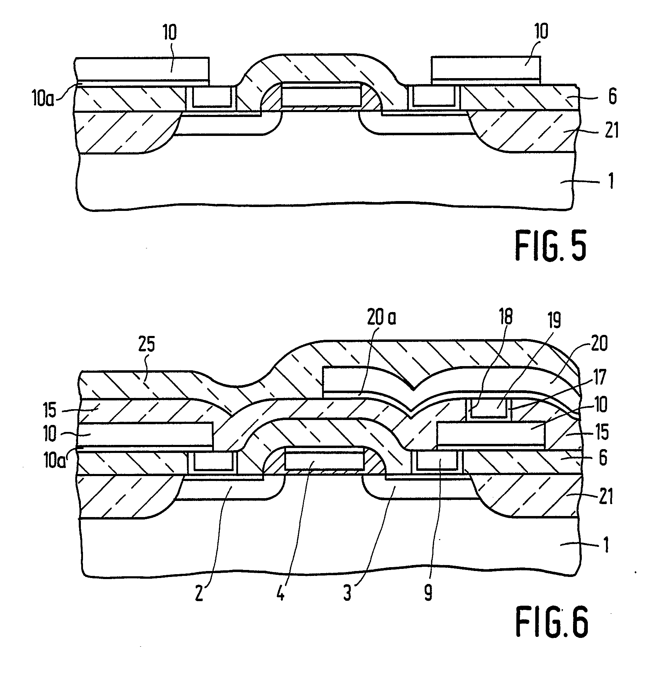

Die Schicht 10 wird dann zum Bilden der gewünschten Leiterbahnen nach Maskierung durch eine Photolackschicht 12 (siehe Figur 4) in einem Plasma aus $Cl_2 + BCl_3 + Ar$ geätzt (siehe Fig. 5). Die Schicht 10 läßt sehr gut ätzen, da in ihr keine störenden Cu-haltigen Ausfällungen gebildet sind.

Anschließend wird, wie in Fig. 6 dargestellt, die Oberfläche des Halbleiterkörpers mit den Leiterbahnen 10 mit einer weiteren Siliciumoxidschicht 15 bedeckt, in der, wie oben anhand der Fig. 2 und 3 beschrieben, Kontaktöffnungen 17 und darin Verbindungsmetallisierungen 18, 19 gebildet werden. Auf der durch die Siliciumoxidschicht 15 und die Kontakte 18, 19 gebildeten Oberfläche wird dann ebenso wie oben beschrieben, eine weitere Al-(Si,Cu)-Schicht 20a, 20 von 1 μm Dicke niedergeschlagen und zur Bildung von Leiterbahnen durch Plasma-Ätzen strukturiert.

Schließlich wird die gesamte Oberfläche mit einer letzten Siliciumschicht bedeckt und das Ganze dann einer Temperaturbehandlung bei 420 bis 450 °C über 30 min unterworfen, wobei sich in den Al (Si,Cu)-Schichten die mit Rücksicht zu mögliche Elektromigration gewünschte Cu-haltigen Ausfällungen an den Al-Korngrenzen bilden. Diese Temperaturbehandlung kann auch schon nach dem Ätzen der ersten Al(Si,Cu)-Schicht 10 erfolgen.

Die Temperaturbehandlung der Al(Si,Cu)-Schicht sollte aber erst nach dem Bedecken dieser Schicht mit einer Oxidschicht erfolgen, da sonst störende Erhöhungen (hillocks) auf der Al-Schicht entstehen könnten.

Die Siliciumschichten 15, 20 über den Al-Schichten 10, 20 sollten bei relativ niedrigen Temperaturen gebildet werden, z.B. mit einem Plasma-unterstützten Verfahren (PECVD).

## Ansprüche

1. Verfahren zum Herstellen von Halbleiterbauelementen, bei dem auf einer Oberfläche des Halbleiterkörpers Leiterbahnen dadurch gebildet werden, daß eine Schicht aus Al (Cu) abgeschieden wird und anschließend durch Ätzen strukturiert wird,
**dadurch gekennzeichnet,**
daß zunächst soviel Al (Si) abgeschieden wird, daß sich gerade eine kontinuierliche Schicht bildet und dann im selben Arbeitsgang weiter Al (Si, Cu) abgeschieden wird bis die gewünschte Schichtdicke erreicht ist.

2. Verfahren nach Anspruch 1,
**dadurch gekennzeichnet,**
daß die Temperatur beim Abscheiden des Al (Si, Cu) gegenüber der Temperatur beim Niederschlagen des Al (Si) erhöht ist.

3. Verfahren nach Anspruch 2,
**dadurch gekennzeichnet,**
daß Al (Si) bei einer Temperatur zwischen 100 und 150 °C abgeschieden wird.

4. Verfahren nach Anspruch 3,
**dadurch gekennzeichnet,**
daß die Temperatur etwa 150 °C beträgt.

5. Verfahren nach Anspruch 2,
**dadurch gekennzeichnet,**
daß Al (Si, Cu) bei einer Temperatur zwischen 200 und 400 °C abgeschieden wird.

6. Verfahren nach Anspruch 5,
**dadurch gekennzeichnet,**
daß die Temperatur etwa 300 °C beträgt.

7. Verfahren nach Anspruch 1,
**dadurch gekennzeichnet,**
daß das abgeschiedene Al (Si) zwischen 0 und etwa 2 Gew.% Si enthält.

8. Verfahren nach Anspruch 1,
**dadurch gekennzeichnet,**
daß das abgeschiedene Al(Si) etwa 1 Gew.% Si enthält.

9. Verfahren nach Anspruch 1,
**dadurch gekennzeichnet,**
daß das abgeschiedene Al (Si,Cu) etwa 0,5 - 4 Gew.% Cu enthält.

10. Verfahren nach Anspruch 9,
**dadurch gekennzeichnet,**
daß das abgeschiedene Al (Si,Cu) etwa 2 Gew.% Cu enthält.

11. Verfahren nach Anspruch 2,
**dadurch gekennzeichnet,**
daß die Dicke der zunächst abgeschiedenen Al (Si)-Schicht bei einer Abscheidungstemperatur von 100 - 150 °C etwa 50 nm beträgt.

12. Verfahren nach Anspruch 1,
**dadurch gekennzeichnet,**
daß die Dicke der gesamten abgeschiedenen Schicht etwa 0,5 - 1,5 μm beträgt.

13. Verfahren nach einem der vorangehenden Ansprüche,
**dadurch gekennzeichnet,**
daß die Schicht durch DC-Magnetron-Sputtern abgeschieden wird.

14. Verfahren nach einem der vorangehenden Ansprüche,
**dadurch gekennzeichnet,**
daß die Oberfläche des Halbleiterkörpers auf der abgeschieden wird, mit TiW, $SiO_2$, TiN, $Si_3N_4$, Si, W oder $Al_2O_3$ bedeckt ist.

15. Verfahren nach Anspruch 1,
**dadurch gekennzeichnet,**
daß die abgeschiedene Al(Si,Cu)-Schicht nach dem Ätzen einer Temperaturbehandlung unterworfen wird.

16. Verfahren nach Anspruch 13,
**dadurch gekennzeichnet,**
daß die Al(Si,Cu)-Schicht über eine Zeit von 30 bis 60 min auf eine Temperatur von 400 bis 450 °C erhöht wird.

FIG.1

FIG.2

FIG.3

FIG.4

1-II-PHQ 88-021

FIG.5

FIG.6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | THIN SOLID FILMS - 15TH INT. CONG. ON METALLURGICAL COATINGS, San Diego, 11.-15. April 1988, Band 166, Elsevier Sequoia, Lausanne, CH; J.G. RYAN et al.: "Reactive-ion-etch-compatible metallization for partially covered contact applications" * Seite 59, Absatz 2 * --- | 1 | H 01 L 23/485 H 01 L 21/320 |
| A | GB-A-2 169 446 (MOTOROLA) * Zusammenfassung * ----- | 1 | |

RECHERCHIERTE SACHGEBIETE (Int. Cl.5)

H 01 L

Der vorliegende Recherchenbericht wurde für alle Patentansprüche erstellt

| Recherchenort | Abschlußdatum der Recherche | Prüfer |
|---|---|---|
| DEN HAAG | 18-12-1989 | PHEASANT N.J. |